# EUROPEAN PATENT SPECIFICATION

(11) **EP 0 420 136 B1**
(45) Date of publication and mention of the grant of the patent: **17.03.1993**
(21) Application number: 90118370.7
(22) Date of filing: 25.09.1990
(51) Int. Cl.: G01L 3/10, H01L 41/12

(54) **Method of producing magnetostriction type torque sensor shafts**
Verfahren zum Herstellen der Welle eines magnetostriktiven Drehmomentsensors
Procédé pour produire l'arbre d'un transducteur de couple magnétostrictif

(30) Priority: 25.09.1989 JP 249821/89
(43) Date of publication of application: 03.04.1991
(73) Proprietor: Kubota Corporation, Naniwa-ku, Osaka (JP)
(72) Inventor: Ishino, Renshiro, c/o Kubota Corporation, Hirakata-shi, Osaka-fu (JP); Shibata, Yoshio, c/o Kubota Corporation, Hirakata-shi, Osaka-fu (JP)
(74) Representative: Vonnemann, Gerhard, Dr.-Ing.

(56) References cited:
- DE-A- 3 704 049
- US-A- 4 760 745

## Description

### FIELD OF THE INVENTION

The present invention relates to a method of producing torque sensor shafts and more particularly it relates to a method of producing magnetostriction type torque sensor shafts adapted to detect changes in permeability particularly during torque application.

### BACKGROUND OF THE INVENTION

Magnetostriction type torque sensor shafts have been known, as one is shown in Japanese Patent No. 169,326, wherein the surface of a sensor shaft adapted to have torque transmitted thereto is formed with a magnetically anisotropic section by forming spiral grooves therein by cutting or rolling so as to detect changes in the permeability of the magnetic anisotropic section to express them in terms of electrical quantities. However, the provision of spiral grooves makes it only possible to provide a sensor whose hysteresis is usually not less than 10% FS; a sensor based on this method has not been put into practical use. Recently, to put this basic principle into practical use, as found in U.S. Pat. No. 4,933,580, shot peening has been applied to grooved portion to decrease hysteresis and improve sensitivity, thus providing a knurled type magnetostrictive torque sensor.

In the invention of a magnetostrictive torque sensor described in U.S. Pat. No. 4,933,580, shot peening is applied to the grooved portion of a sensor shaft and to areas therearoud thereby mechanically, metallurgically and magnetically improve the outermost surface layer of the grooved portion to reduce hysteresis and increase sensitivity. That is, the following techniques are disclosed therein.

### (1) Improvement of Mechanical and Metallurgical Strength of Grooves and Areas therearound:

Application of shot peening to grooves and areas therearound martensitizes the residual austenite in the outermost surface layer produced during carburization to shafts to thereby increase hardness and it decreases crystal grain size, whereby the strength of the outermost surface layer through which magnetic flux passes is increased to a great extent. As a result, when torque is applied, sufficient strength is provided to resist the stress concentrated in the grooves. Even if a large stress is applied, there is little possibility of producing a macroscopic mechanical plastic deformation or a plastic deformation on the microscopic crystalline level or, in other words, a magnetic plastic deformation, which causes the first-mentioned plastic deformation. As a result, the hysteresis characteristic is improved. An auxiliary effect obtained is that the sensitivity is increased owing to the nonmagnetic residual austenite being converted to ferromagnetic martensite.

### (2) Effect of Mending Microcracks in Grooves and Areas therearound:

Generally, microcracks are often produced in grooves and areas therearound during machining, particularly rolling.

Such microcracks aggravate the hysteresis characteristic and lower the sensitivity of sensors.

As is well known, shot peening has the effect of mending such microcracks and hence it is useful for improving the hysteresis characteristic and increasing the sensor sensitivity.

### (3) Improvements in Magnetization of Outermost Surface Layers of Sensors:

Usually, magnetostrictive sensors are magnetized in a low magnetic field having a magnetic intensity of tens of oersteds at 10 kHz to 100 kHz. In most cases, the skin depth is about 0.1 mm immediately below the outermost surface layer and the magnetization process is based mostly on the domain wall displacement.

In this case, the presence of impurities and nonmagnetic inclusions in the skin depth region forms a cause of magnetic hysteresis, and since shaft materials in common use cannot avoid these impurities, it has been usual that the hysteresis characteristic is bad.

On the other hand, application of shot peening results in forming microscopic unevenness in the grooves and areas therearound which form the sensor.

According to the teachings of physics of magnetism, formation of microscopic pits on a metal surface by plastic deformation results in formation of stable magnetic domains around the microscopic pits due to annual residual stress, with the magnetization process in the annular stable magnetic domains converting to magnetization rotation with less magnetic hysteresis, thereby lowering the hysteresis characteristic of the sensor.

With the above effects organically coupled together, application of shot peening brings about a decrease in hysteresis and an increase in sensitivity.

The action based on the effect (3) is based on the action of residual stress distribution applied to a region in the vicinity of the outermost surface layer.

Conventionally, when shot peening is applied to the surface of a sensor shaft, only shot particles of uniform size have been used. If the size of shot particles is large, a stress distribution in which the compressive residual stress is at a maximum and approximately constant is formed in a deep region below the shaft surface in a wide range as seen in the direction of the depth. Further, if the size of the shot particles is small, a peak value of compressive residual stress is obtained in a shallow region, but in this case the region where the compressive residual stress is approximately constant is narrow.

For this reason, in the case where the size of shot particles is small, excitation conditions using high frequency ac currents are utilized to ensure shallow penetration of magnetic flux; in this manner, optimum excitation conditions are provided. However, since the region where the compressive residual stress is approximately constant is narrow, it has been necessary that the range of utilizable excitation frequency be from 50 kHz to 100 kHz, which are considerably high frequencies

On the other hand, in the case where the size of shot particles is large, excitation conditions using low frequencies (usually, about 10 kHz) to enable magnetic flux to penetrate into depths are selected so that the depth of penetration of magnetic flux is greater than when the size of shot particles is small and so as to minimize the influence on the outermost surface layer of the shaft where the changes in stress distribution is large and where- the compressive residual stress is small; in this manner, hysteresis and sensitivity are improved. However, in this case, the region of the shaft near its surface aggravates the sensor characteristics. Therefore, when it is desired to obtain satisfactory hysteresis characteristics, it has been necessary to use a large excitation current.

In torque sensor shafts having such conventional shot peening methods applied thereto, the range in which the compressive residual stress is approximately constant does not necessarily have a sufficient expanse, so that there is a problem that the range of usable excitation frequencies is narrow.

### DISCLOSURE OF THE INVENTION

The present invention is intended to solve such problems and its object is to enlarge the range in which the compressive residual stress is approximately constant from the outermost surface layer toward the shaft center to thereby enlarge the optimum frequency range.

To achieve this object, a method of producing torque sensor shafts of magnetostrictive type according to the invention adapted to detect changes in permeability when torque is applied, is characterized by applying a plurality of times of shot peening to the surface of a torque sensor shaft by successively using shot particles of various diameters from large to small diameter.

With this scheme, first with shot particles of large diameter, a distribution in which the compressive residual stress is at a maximum and constant is obtained in a deep region below the shaft surface. Subsequently, by successively applying shot peening operations using shot particles of successively smaller diameters, the region in which the compressive residual stress is at a maximum and approximately constant is progressively enlarged toward a shallower region below the outermost surface layer of the shaft. Therefore, finally, the region in which the compressive residual stress is at a maximum and approximately constant lies over a wide range as seen in the direction of the depth. As a result, a reduction in hysteresis and an increase in sensitivity are attained and, as shown in the following embodiments, the nonlinearity can be improved and it becomes possible to use a wide range of excitation conditions.

### BRIEF DESCRIPTION OF THE DRAWINGS

Fig. 1 is a diagram showing a distribution of residual stress in the interior of a torque sensor shaft according to an embodiment of the invention;
Fig. 2 is a diagram showing frequency characteristics versus hysteresis and nonlinearity for a torque sensor according to an embodiment of the invention; and
Fig. 3 is a view showing a knurled portion of a torque sensor of knurled type.

### DESCRIPTION OF THE EMBODIMENTS

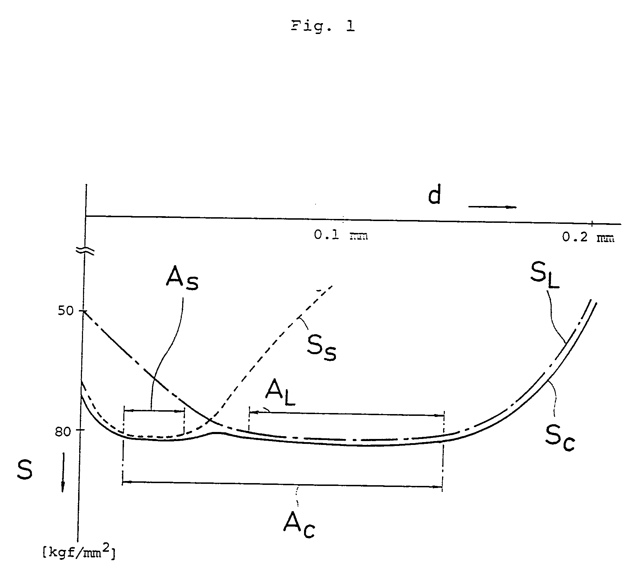

Fig. 1 shows a distribution of compressive residual stress in the interior of a shaft (structural steel SNCM 815, specified in JIS) when the surface of said shaft is subjected to shot peening first with shot particles of large diameter (0.6 mm) and then with shot particles of smaller diameter (44 µm). The vertical axis represents the magnitude of the compressive residual stress S and the horizontal axis represents the depth d measured from the shaft surface. In the diagram, the dash-dot line indicates a compressive residual stress distribution S_{L} obtained by effecting shot peening with shot particles of large diameter (0.6 mm) alone and the broken line indicates a compressive residual stress distribution S_{S} obtained by effecting shot peening with shot particles of small diameter (44 µm) alone. The solid line indicates a stress distribution S_{C} obtained by effecting shot peening first with shot particles of large diameter (0.6 mm) and then with shot particles of small diameter (44 µm).

As previously described, in the case where shot peening is effected with shot particles of large diameter (0.6 mm) alone, an area A_{L} where the compressive residual stress is at a maximum and approximately constant appears in a deep region from the shaft surface in a wide range (from 0.05 mm to about 0.15 mm) as seen in the direction of the depth . In the case where shot peening is effected with shot particles of small diameter (44 µm), an area A_{S} where the compressive residual stress is at a maximum and approximately constant appears in a shallow region from the shaft surface in a narrow range (from about 0 to 0.05 mm).

In the case where shot peening is effected first with shot particles of large diameter (o.6 mm) and then with shot particles of small diameter (44 µm), the range A_{C} in which the compressive residual stress is at a maximum and approximately constant is wide (from about 0 to 0.15 mm in the direction of the depth), extending close to the shaft surface. Therefore, as compared with the case of using shot particles of one fixed diameter alone, it becomes possible to use a wide range of excitation conditions to enlarge the range of use of torque sensors.

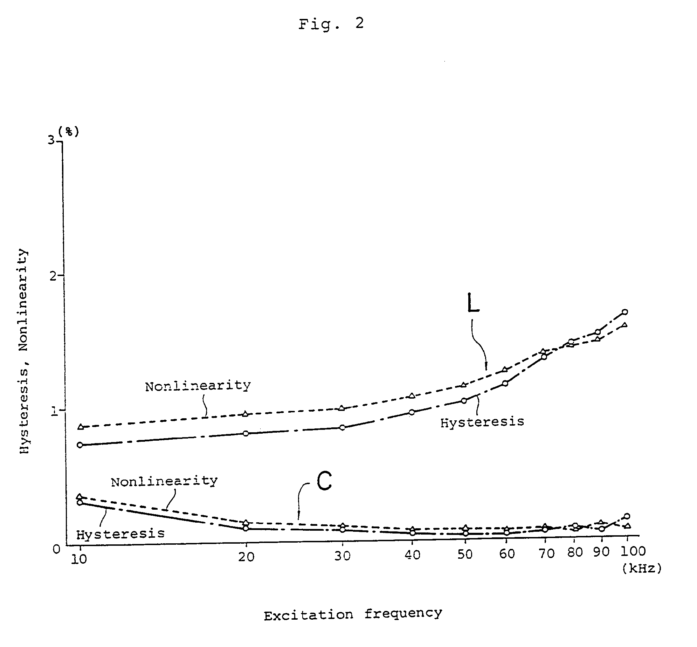

Fig. 2 shows an example of frequency characteristic versus hysteresis and nonlinearity for a torque sensor shaft produced by the method of the present invention. The shaft material used was SNCM 815 steel specified in JIS (Japanese Industrial Standard). The shaft was subjected to shot peening first with steel particles of 0.6 mm in diameter at a shot pressure of 5 kgf/cm² and a coverage of not less than 70%. and then with steel particles of 44 µm in diameter at a shot pressure of 5 kgf/cm² and a coverage of not less than 70%. The sensor characteristic was measured by constant voltage drive with an effective excitation current of 35.5 mA while changing the frequency. In the figure, the lower group of curves C show the hysteresis and nonlinearity measured. The upper group of curves L are for a control example, showing the result obtained by a measurement under the same conditions for the same shaft material when shot peening was effected only once with steel particles of 0.6 mm in diameter at a shot pressure of 7 kgf/cm² and a coverage of not less than 70%. As is clear from the figure, according to the method of the present invention, as compared with the case of using only one kind of particles, not only hysteresis but also nonlinearity is improved.

As for the magnitude of the compressive residual stress in the outermost surface layer due to shot peening, in the case of shot peening with steel shots of 0.6 mm in diameter, as shown in Fig. 1, a compressive residual stress of about 50 kgf/cm² appears both axially and circumferentially, while application of shot peening first with shots of 0.6 mm in diameter and then with shots of 44 µm in diameter results in a compressive residual stress of about 70 kgf/cm² appearing both axially and circumferentially, achieving improvements in hysteresis, nonlinearity and sensitivity. Experiments of shot peening were conducted by changing shot peening conditions. As a result, it was found that if the compressive residual stress in the outermost surface layer was not less than about 20 kgf/cm² and a region where the compressive residual stress was not less than about 20 kgf/cm² , extends from the outermost surface layer to an area not less than 0.1 mm deep, this was very effective for improving hysteresis, nonlinearity and sensitivity.

What should be noted here is that while U.S. PAT. No. 4,933,580 discloses that shot peening is useful for greatly decreasing hysteresis and increasing sensitivity, the present invention has proved that shot peening is also useful for improving nonlinearity. In other words, special mention should be made of the fact that shot peening greatly improves all of the fundamental factors for a sensor, i.e. hysteresis, nonlinearity and sensitivity; thus, the utility value of shot peening is very high.

Further, as is clear from Fig. 2, according to the invention, as compared with the case of effecting shot peening with steel particles of 0.6 mm in diameter alone, both hysteresis and nonlinearity are improved over the entire range of excitation frequency used in measurement. The reason is that shot peening first with steel particles of 0.6 mm in diameter and then with steel particles of 44 µm in diameter ensures that the compressive residual stress distribution in the vicinity of the outermost surface layer where a maximum stress occurs when stress is measured by a torque sensor is a uniform distribution in which when excitation is effected using a wide frequency range from 10 kHz to 100 kHz, the compressive residual stress is at a maximum and uniform over the entire skin depth range through which the magnetic flux passes.

The reason why nonlinearity is improved as described above is that the magnetic anisotropy of grooves is heightened.

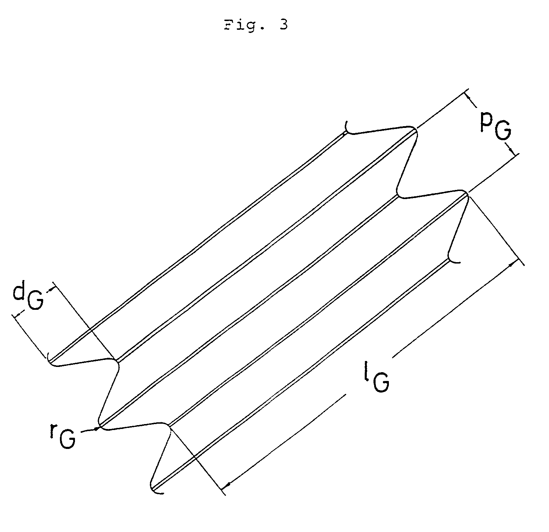

According to our study, application of shot peening to the magnetically anisotropic portions which are the grooves results in generation of residual stress in the magnetically anisotropic portions. As shown in knurling configuration shown in Fig. 3, in the case where the dimension in the direction of the grooves is longer than that in the direction orthogonal thereto (i.e., in the direction of the width), in other words, in the case where slender grooves are formed, generally the relation "compressive residual stress in the direction of the grooves < compressive residual stress in the direction of the width" holds true (refer to the text for the symposium entitled "Residual Stresses and Shot Peening" held by Japanese "Shot Peening Technology Association", January 28, 1990, p.19, Isuke Iida, a professor at Meiji University). As a result, the direction of the grooves becomes the easy direction of magnetization.

Further, according to the invention, since shot peening is effected first with shot particles of large diameter and then with shot particles of small diameter, microcracks often produced by shot particles of large diameter are mended by shot particles of small diameter. As a result, the surface quality of the torque sensor shaft is improved and the strength of the shaft is increased; from this point of view, hysteresis and nonlinearity are improved. Further, to promote the effects of shot peening, we have found that the diameter of shot particles for the second and subsequent shot peening should be smaller than that of the rounded bottoms of grooves. In the embodiment described above, for grooves of the configuration shown in Fig. 3 with a groove pitch P_{G} of 1 mm, a groove depth d_{G} of 0.8 mm, a groove length l_{G} of 20 mm, and a groove bottom diameter r_{G} of 0.2 mm, the diameter of the first shot particles was 0.6 mm and that of the second was 44 µm.

In addition, the above embodiment refers to the case of using two kinds of shot particles having large and small diameters, respectively; however, three or more kinds of shot particles differing in diameter may be used so long as a plurality of times of shot peening are effected using shot particles with successively decreasing diameters. If, however, the order is reversed to use shot particles of small diameter first and then shot particles of large diameter, the effects brought about by shot particles of small diameter are killed by shot particles of large diameter, so that the intended frequency characteristics cannot be attained. Similarly, if a mixture of shot particles of large and small diameters is used for a single shot peening operation, neither hysteresis nor nonlinearity is improved.

Finally, application of heat treatments will now be described. To increase the strength of sensor shafts, it is effective to apply the shot peening process according to the invention subsequently to a generally performed heat treatment, such as carburizing, induction hardening or carbonitriding. In this case, in order to provide effective residual stress it was found particularly effective to make the hardness of shot particles greater than that of the outermost surface layer.

## Claims

1. A method of producing magnetostriction type torque sensor shafts in which magnetically anisotropic portions are formed on the surface of the shaft by grooved portions which sensors are adapted to detect a change in permeability of the magnetically anisotropic portions when a torque is applied, characterized in that:
shot peening is applied a plurality of times to the grooved portions of said torque sensor shaft in such a manner that the diameter of shot particles to be used is decreased each time.

2. A method of producing magnetostriction type torque sensor shafts as set forth in Claim 1, characterized in that two kinds of shot particles different in diameter are used.

3. A method of producing magnetostriction type torque sensor shafts as set forth in Claim 1, characterized in that three or more kinds of shot particles different in diameter are used.

4. A method of producing magnetostriction type torque sensor shafts as set forth in Claim 1, characterized in that the diameters of shot particles for the second and following shot peening operations are smaller than the diameter of the rounded bottoms of grooves.

5. A method of producing magnetostriction type torque sensor shafts as set forth in Claim 1, characterized in that the compressive residual stress in a skin depth region is not less than 20 kgf/cm², said region extending from 0 to about 0.1 mm in the direction of the depth.

## Patentansprüche

1. Verfahren zur Herstellung einer Drehmomentmeßwelle vom magnetostriktiven Typ, bei dem magnetisch anisotrope Teile durch genutete Bereiche auf der Oberfläche der Welle erzeugt werden, deren Sensoren zur Ermittlung einer
Permeabilitätsänderung der anisotropen Bereiche ausgebildet sind, sobald ein Drehmoment angelegt ist, **dadurch gekennzeichnet, daß die** genuteten Bereiche der Drehmomentmeßwelle mehrfach in einer Weise kugelgestrahlt werden, daß der Druchmesser der benutzten Schrotpartikel jedesmal verringert wird.

2. Verfahren zur Herstellung einer Drehmomentmeßwelle vom magnetorstriktiven Typ gemäß Anspruch 1, **dadurch gekennzeichnet** , daß zwei im Durchmesser sich unterscheidende Arten von Schrotpartikeln benutzt werden.

3. Verfahren zur Herstellung einer Drehmomentmeßwelle vom magnetorstriktiven Typ gemäß Anspruch 1, **dadurch gekennzeichnet,** daß drei oder mehrere sich im Durchmesser unterscheidende Schrotpartikel benutzt werden.

4. Verfahren zur Herstellung einer Drehmomentmeßwelle vom magnetorstriktiven Typ gemäß Anspruch 1, **dadurch gekennzeichnet,** daß die Durchmesser der Schrotpartikel für den zweiten und folgenden Kugelstrahlvorgang kleiner als der Druchmesser der gerundeten Talsohlen der Nuten sind.

5. Verfahren zur Herstellung einer Drehmomentmeßwelle vom magnetorstriktiven Typ gemäß Anspruch 1, **dadurch gekennzeichnet,** daß die verbleibende Druckeigenspannung in einem Hauttiefenbereich nicht weniger als 2 N/mm² (20 kgF/cm²) beträgt, wobei der Bereich in Tiefenrichtung sich von 0 bis ungefähr 0,1 mm erstreckt.

## Revendications

1. Procédé pour produire l'arbre d'un transducteur de couple magnétostrictif dans lequel des zones magnétiquement anisotropes sont constituées à la surface de l'arbre par des sillons auxquels les transducteurs sont adaptés pour détecter une modification de perméabilité des zones magnétiquement anisotrope lorsqu'on y applique un couple, caractérisé en ce qu'une pluralité de grenaillages est appliquée aux sillons de l'arbre du transducteur de couple de telle sorte que le diamètre des grains de grenaillage à utiliser décroît d'un grenaillage à l'autre.

2. Procédé selon la revendication 1 caractérisé en ce que deux sortes de grains différents en diamètre sont utilisés.

3. Procédé selon la revendication 2 caractérisé en ce que trois sortes ou plus de grains différents en diamètre sont utilisés.

4. Procédé selon la revendication 1 caractérisé en ce que les diamètres des grains pour la seconde opération de grenaillage et les suivantes sont plus petits que le diamètre des arrondis de fond de filet.

5. Procédé selon la revendication 1 caractérisé en ce que la contrainte résiduelle de compression dans la zone de peau n'est pas inférieure à 1,96 MPa, la zone s'étendant entre 0 et à peu près 0,1 mm dans la direction de la profondeur.
